# EUROPÄISCHE PATENTANMELDUNG

(11) **EP 4 797 467 A1**
(43) Veröffentlichungstag der Anmeldung: **26.08.2026**
(21) Anmeldenummer: 26159791.8
(22) Anmeldetag: 20.02.2026
(51) Int. Cl.: H01S 3/04, H01S 3/0941, H01S 5/0225, H01S 5/02326, H01S 3/02, H01S 3/042, H01S 3/06, H01S 3/094

(54) **PUMPVORRICHTUNG UND LASERANORDNUNG MIT EINER SOLCHEN PUMPVORRICHTUNG**

(30) Priorität: 20.02.2025 DE 102025106478
(71) Anmelder: TRUMPF Laser SE, 78713 Schramberg (DE); Active Medical Xcellence GmbH, 07745 Jena (DE)
(72) Erfinder: Elbrecht, Jens, 07751 Jena (DE); Brückner, Daniel, 07751 Zöllnitz (DE)
(74) Vertreter: Schneiders & Behrendt Bochum

(57) **Zusammenfassung**

Die Erfindung betrifft eine Pumpvorrichtung (3) zum optischen Pumpen eines Lasermediums (5), mit einer Pumpkammer (7) zur Aufnahme des Lasermediums (5), wobei die Pumpvorrichtung (3) eine Pumplichtführung (9) aufweist, die mindestens eine Lichtleitvorrichtung (11) aufweist, die sich von einer zum Halten einer mindestens eine Laserdiode aufweisenden Pumplichtquelle (13) eingerichteten Pumpquellenhalterung (15) der Pumpvorrichtung (3) bis unmittelbar zu der Pumpkammer (7) erstreckt, wobei die mindestens eine Lichtleitvorrichtung (11) ein als für die Strahlung der Pumplichtquelle (13) transparenter Volumenkörper (17) ausgebildetes Lichtleitmedium (19) aufweist, wobei das Lichtleitmedium (19) im Bereich der Pumpquellenhalterung (15) eine Einkoppelfläche (21) aufweist, die derart ausgebildet ist, dass die Strahlung der Pumplichtquelle (13) in die Lichtleitvorrichtung (11) eingekoppelt werden kann, wenn die Pumplichtquelle (13) an der Pumpquellenhalterung (15) angeordnet ist, und wobei das Lichtleitmedium (19) keilförmig, mit zwei konvergenten Seitenflächen (23), ausgebildet ist, wobei sich die konvergenten Seitenflächen (23) in einer gedachten Ebene, die senkrecht auf einer Längsachse (L) der Pumpkammer (7) steht, einander in Richtung der Pumpkammer (7) annähern. Das Lichtleitmedium (19) grenzt dabei unmittelbar an die Pumpkammer (7) an, wobei zwischen der Pumpkammer (7) und dem Lichtleitmedium (19) kein Luftspalt und auch kein anderes Medium vorhanden ist, und wobei sich das Lichtleitmedium (19) optisch durchgehend, ohne weitere optische Grenzfläche, zwischen der Pumpquellenhalterung (15) und der Pumpkammer (7) erstreckt.

## Beschreibung

Die Erfindung betrifft eine Pumpvorrichtung und eine Laseranordnung mit einer solchen Pumpvorrichtung.

Lasermedien werden vermehrt durch Laserdioden optisch gepumpt. Die Fokussierung und Strahlformung von Laserdioden stellt allerdings eine große Herausforderung dar und verlangt aufwändige sowie schwer justierbare refraktive oder diffraktive Optiken. Besonders beim leistungsstarken Pumpen von Lasermedien stellt die Fokussierbarkeit der Diodenpumpstrahlung oft den laserleistungsbegrenzenden Faktor dar. Dabei werden typischerweise einzelne Zeilen von Laserdioden eingesetzt, die in Richtung einer Längs- oder Symmetrieachse des Lasermediums angeordnet sind, wobei die schnelle Achse (Fast Axis) der Laserdioden senkrecht zur Längs- oder Symmetrieachse des Lasermediums ausgerichtet ist, und wobei die refraktive oder diffraktiven Optiken eingesetzt werden, um das Pumplicht entlang der schnellen Achse zu bündeln oder zu kollimieren, was komplex und teuer ist. Ein weiteres Problem stellt die effiziente Kühlung sowohl des Lasermediums als auch der Laserdioden dar.

Die US 2003/0206569 A1 beschreibt einen seitlich gepumpten Rod-Laser mit Kühlhülse und diffusiv-/spiegelflektierender Röhre. Die Pumpeinheit nutzt ein Stack-Laserdioden-Array, Zylinderlinsen und asphärische Linsen zur Fokussierung. Ein im Schlitz der Röhre gehaltener hexaedrischer Slab-Waveguide ist vorgesehen, um das Pumplicht in die Röhre zu führen; zwischen Slab und Schlitz liegt eine adhäsive Schicht mit kleinerem Brechungsindex. Der Lichtleiter wird mit weiteren refraktiven optischen Elementen (Linsen) betrieben. Aufgrund der Vielzahl der optischen Grenzflächen zwischen Waveguide und adhäsiver Schicht, zwischen adhäsiver Schicht und Röhre sowie an den Oberflächen der refraktiven optischen Elemente kommt es zu erheblichen Beugungs-, Brechungs- und Fresnel-Verlusten. Außerdem ist die vorbekannte Anordnung sehr justageempfindlich.

Der Erfindung liegt daher die Aufgabe zugrunde, eine Pumpvorrichtung und eine Laseranordnung mit einer solchen Pumpvorrichtung zu schaffen, wobei die genannten Nachteile zumindest reduziert sind, vorzugsweise vermieden werden.

Die Aufgabe wird gelöst, indem die vorliegende technische Lehre bereitgestellt wird, insbesondere die Lehre der unabhängigen Ansprüche sowie der in den abhängigen Ansprüchen und der Beschreibung offenbarten Ausführungsformen.

Die Aufgabe wird in einem ersten Aspekt insbesondere gelöst, indem eine Pumpvorrichtung zum optischen Pumpen eines Lasermediums geschaffen wird, die eine Pumpkammer zur Aufnahme des Lasermediums aufweist, wobei die Pumpvorrichtung außerdem eine Pumplichtführung aufweist, die mindestens eine Lichtleitvorrichtung aufweist, die sich von einer zum Halten einer mindestens eine Laserdiode aufweisenden Pumplichtquelle eingerichteten Pumpquellenhalterung der Pumpvorrichtung bis unmittelbar zu der Pumpkammer erstreckt, wobei die mindestens eine Lichtleitvorrichtung ein als für die Strahlung der Pumplichtquelle transparenter Volumenkörper ausgebildetes Lichtleitmedium aufweist, wobei das Lichtleitmedium im Bereich der Pumpquellenhalterung eine Einkoppelfläche aufweist, die derart ausgebildet ist, dass die Strahlung der Pumplichtquelle in die Lichtleitvorrichtung eingekoppelt werden kann, wenn die Pumplichtquelle an der Pumpquellenhalterung angeordnet ist, und wobei das Lichtleitmedium keilförmig, mit zwei konvergenten Seitenflächen, ausgebildet ist, wobei sich die konvergenten Seitenflächen in einer gedachten Ebene, die senkrecht auf einer Längsachse der Pumpkammer steht, in Richtung der Pumpkammer einander annähern. Dabei grenzt das Lichtleitmedium unmittelbar an die Pumpkammer an, wobei zwischen der Pumpkammer und dem Lichtleitmedium kein Luftspalt vorhanden ist, und wobei sich das Lichtleitmedium optisch durchgehend zwischen der Pumpquellenhalterung und der Pumpkammer erstreckt.

Durch die Verwendung eines einfachen transparenten Volumenkörpers in der Lichtleitvorrichtung, der sich bis unmittelbar zu der Pumpkammer erstreckt, wird ein einfaches und für Justage unempfindliches Strahlformungssystem bereitgestellt, mittels dem das Pumplicht, das heißt die Strahlung der Pumplichtquelle, äußerst effizient und ohne hohen Justierungs- und Optimierungsaufwand in die Pumpkammer eingekoppelt werden kann. Weiter kann das Lichtleitmedium vorteilhaft so dimensioniert sein, dass als Pumplichtquelle ein Laserdiodenarray verwendet werden kann. Auf diese Weise kann vorteilhaft durch Verwendung einer großen Zahl von Laserdioden eine sehr hohe Pumpleistung in die Pumpkammer eingekoppelt werden. Weiterhin kann so das Lasermedium direkt gepumpt werden, insbesondere ohne schwer zu justierende refraktive oder diffraktive optische Elemente und ohne indirekte Einkopplung über einen Reflektor.

Die Lichtleitvorrichtung, insbesondere das Lichtleitmedium, grenzt unmittelbar an die Pumpkammer an, das heißt zwischen der Pumpkammer und der Lichtleitvorrichtung, insbesondere dem Lichtleitmedium, ist kein Luftspalt und - vorzugsweise - auch kein anderes Medium vorhanden. Vorteilhaft werden auf diese Weise Grenzflächen und damit Fresnelverluste zumindest verringert, insbesondere minimiert oder ganz vermieden. Das Lichtleitmedium kann einteilig, insbesondere materialeinheitlich, mit der Pumpkammer ausgebildet sein.

Gemäß der Erfindung ist vorgesehen, dass sich das Lichtleitmedium durchgehend zwischen der Pumpquellenhalterung und der Pumpkammer erstreckt, und zwar ohne irgendeine weitere optische Grenzfläche. D.h. die Einkoppelfläche ist die einzige optische Grenzfläche. Dies kann auch so bezeichnet werden, dass sich das Lichtleitmedium optisch durchgehend zwischen der Pumpquellenhalterung und der Pumpkammer erstreckt. Vorteilhaft werden auf diese Weise sowohl Beugungs- als auch Brechungsverluste zumindest verringert, insbesondere minimiert oder ganz vermieden. In einer besonders vorteilhaften Ausgestaltung erstreckt sich das Lichtleitmedium einstückig zwischen der Pumpquellenhalterung und der Pumpkammer.

Unter der optisch durchgehenden Erstreckung des Lichtleitmediums zwischen der Pumpquellenhalterung und der Pumpkammer wird im Sinne der Erfindung also verstanden, dass sich im Pumpstrahlengang zwischen der Pumpquellenhalterung und der Pumpkammer keinerlei refraktive oder diffraktive optische Elemente befinden. Insbesondere sind weder Linsen noch Prismen oder diffraktive Elemente vorhanden, die dazu dienen könnten, das von der Pumplichtquelle abgegebene Licht zur Einkopplung in die Lichtleitvorrichtung zu fokussieren, zu kollimieren, umzulenken oder anderweitig optisch zu formen. Das Lichtleitmedium ist vielmehr so ausgebildet und angeordnet, dass die Pumpstrahlung unmittelbar von der Pumplichtquelle über die Einkoppelfläche und das Lichtleitmedium bis zur Pumpkammer geführt wird, wobei die Führung ausschließlich durch Reflexion und/oder Totalreflexion an definierten Flächen des Lichtleitmediums erfolgt. Die Funktionseinheit zwischen Pumpquellenhalterung und Pumpkammer ist somit optisch homogen und frei von optisch wirksamen, die Strahlung verändernden, refraktiven oder diffraktiven Bauteilen im Strahlengang. Diese Ausgestaltung gewährleistet einen direkten, verlustarmen und justageunempfindlichen Transfer der Pumpstrahlung in das Lasermedium, ohne die Nachteile aufwändiger oder schwer justierbarer refraktiver oder diffraktiver Optiken.

In einer Ausführungsform, in der die Pumpkammer nicht einteilig mit dem Lichtleitmedium ausgebildet ist, weist die Pumpkammer eine Anlagefläche, insbesondere in Form einer Abflachung, auf, an der das Lichtleitmedium bündig, das heißt ohne Spalt, anliegt.

In einer Ausgestaltung weist das Lichtleitmedium, insbesondere der transparente Volumenkörper, ein Material auf, oder das Lichtleitmedium besteht aus einem Material, das ausgewählt ist aus einer Gruppe, bestehend aus Quarz, Quarzglas, Glas, Kunststoff, und einer Kombination aus wenigstens zwei der genannten Materialien. Insbesondere ist das Material transparent bei 790 nm. Alternativ oder zusätzlich weist das Lichtleitmedium zumindest an den konvergenten Seitenflächen - bevorzugt auch an seinen anderen Flächen - glatte Oberflächen auf. Insbesondere sind die konvergenten Seitenflächen glatt. Vorteilhaft werden auf diese Weise Streuverluste zumindest verringert, insbesondere minimiert oder vermieden.

Alternativ oder zusätzlich weist die Pumpkammer ein Material auf oder besteht aus einem Material, das ausgewählt ist aus einer Gruppe, bestehend aus Quarz, Quarzglas, Glas, Kunststoff, und einer Kombination aus wenigstens zwei der genannten Materialien. Insbesondere ist das Material transparent bei 790 nm.

In einer Ausführungsform ist das Lichtleitmedium, insbesondere der transparente Volumenkörper, als monolithischer Körper, insbesondere als monolithischer Quarzkörper, hergestellt. Alternativ oder zusätzlich ist das Lichtleitmedium, insbesondere der transparente Volumenkörper, in einem additiven Verfahren oder in einem Sol-Gel-Verfahren hergestellt.

Insbesondere weist das als transparenter Volumenkörper ausgebildete Lichtleitmedium keine diffraktiven oder refraktiven Eigenschaften auf. Insbesondere ist das Lichtleitmedium nicht als Linse ausgebildet, das heißt es weist keinen Linseneffekt auf. Vielmehr wirkt das Lichtleitmedium allein durch Reflexion an den konvergenten Seitenflächen auf die Strahlung der Pumplichtquelle.

In einer Ausführungsform ist die Einkoppelfläche eine ebene Fläche, die insbesondere parallel zu einer Abstrahlfläche der Pumplichtquelle angeordnet ist, wenn die Pumplichtquelle bestimmungsgemäß an der Pumpquellenhalterung angeordnet ist. Auf diese Weise kann das Pumplicht sehr effizient in das Lichtleitmedium eingekoppelt werden.

Es ist möglich, dass zwischen der Einkoppelfläche und der Abstrahlfläche ein Spalt, insbesondere ein Medienspalt oder Luftspalt, angeordnet ist. Ein solcher Spalt kann insbesondere zu Justagezwecken vorgesehen sein. In einer Ausgestaltung ist dieser Spalt der einzige Spalt zwischen der Abstrahlfläche und der Pumpkammer, insbesondere der einzige Medienspalt oder Luftspalt. Insbesondere auf diese Weise werden Grenzflächen und damit Fresnelverluste zumindest verringert, insbesondere minimiert oder vermieden.

In einer Ausgestaltung weist die Einkoppelfläche eine Antireflexbeschichtung auf. Das Pumplicht wird vorteilhaft so besonders verlustarm in das Lichtleitmedium eingekoppelt.

Unter einer Pumpkammer wird im Kontext der vorliegenden technischen Lehre insbesondere eine gegenüber einer äußeren Umgebung geschlossene Kammer verstanden, die ausgebildet ist zur Aufnahme des Lasermediums. In einer Ausgestaltung ist die Pumpkammer als Hohlzylinder ausgebildet.

In einer Ausführungsform ist das Lasermedium ein Festkörper. In einer Ausgestaltung ist das Lasermedium stabförmig ausgebildet, das heißt als Laserstab. Alternativ ist das Lasermedium scheibenförmigen ausgebildet, das heißt als Laserscheibe.

In einer Ausführungsform ist das Lasermedium ausgewählt aus einer Gruppe, bestehend aus: Nd:YAG, Tm:YLF, Tm:YAG, und Ti:Al₂O₃. Alternativ oder zusätzlich ist ein Wirtsmaterial oder Wirtskristall des Lasermediums ausgewählt aus einer Gruppe, bestehend aus: Al₂O₃, Alexandrit, einem Fluorid - insbesondere YLF, BYF, oder KYF -, Glas, CaF₂, einem Sesquioxid - insbesondere Sc₂O₃, oder Lu₂O₃ -, YAG, und YVO₄. Alternativ oder zusätzlich ist ein Dotierungsmaterial des Lasermediums ausgewählt aus einer Gruppe, bestehend aus: Cr, Er, Nd, Pr, Ti, Yb.

Gemäß einer Weiterbildung der Erfindung ist vorgesehen, dass die Pumpquellenhalterung und die Einkoppelfläche derart eingerichtet und aufeinander abgestimmt sind, dass ein Laserdiodenarray als Pumplichtquelle an der Pumpquellenhalterung angeordnet und die Strahlung des Laserdiodenarrays in die Einkoppelfläche eingekoppelt werden kann.

Die Längsachse der Pumpkammer fällt insbesondere mit einer Längsachse oder einer Symmetrieachse des Lasermediums, insbesondere einer Längsachse des Laserstrahls oder einer Symmetrieachse der Laserscheibe zusammen, wenn das Lasermedium in der Pumpkammer bestimmungsgemäß angeordnet ist. Insbesondere ist die Längsachse der Pumpkammer eine Achse längster Erstreckung der Pumpkammer.

Gemäß einer Weiterbildung der Erfindung ist vorgesehen, dass ein Laserdiodenarray an der Pumpquellenhalterung als Pumplichtquelle angeordnet ist, wobei die Pumpquellenhalterung und das Lichtleitmedium derart eingerichtet und aufeinander abgestimmt sind, dass schnelle Achsen der Laserdioden des Laserdiodenarrays parallel zu der Längsachse der Pumpkammer ausgerichtet ist. Insbesondere sind das Laserdiodenarray und das Lichtleitmedium derart relativ zueinander angeordnet, dass die schnellen Achsen der Laserdioden des Laserdiodenarrays parallel zu der Längsachse der Pumpkammer ausgerichtet ist.

Unter einem Laserdiodenarray wird im Kontext der vorliegenden technischen Lehre eine matrixförmige Anordnung von Laserdioden verstanden. Dies bedeutet, dass die Laserdioden in Form von Zeilen und Spalten angeordnet sind. Vorteilhaft kann ein solches Laserdiodenarray aus einer Mehrzahl von Laserdioden-Barren - insbesondere acht, zwölf oder fünfzehn Barren - bestehen, wobei jeder Barren - insbesondere einteilig - entlang seiner Längserstreckung eine Mehrzahl an Laserdioden in Form einer Zeile oder Spalte aufweist. Die Barren sind dann senkrecht zu ihrer Längserstreckung derart nebeneinander angeordnet, dass die nebeneinander angeordneten Laserdioden der einander benachbarten Barren entsprechend Spalten oder Zeilen des Laserdiodenarrays bilden. Die matrixförmig angeordneten Laserdioden bilden gemeinsam die Abstrahlfläche der Pumplichtquelle. Die Anzahl der Barren kann flexibel gewählt werden und bestimmt insbesondere die verfügbare Pumpleistung.

Jede Laserdioden weist eine sogenannte schnelle Achse (Fast Axis) und eine sogenannte langsame Achse (Slow Axis) auf, wobei ein von der Laserdiode emittiertes Strahlungsbündel entlang der schnellen Achse einen größeren Öffnungswinkel aufweist als entlang der langsamen Achse; zugleich ist die Strahlqualität - im Sinne der Fokussierbarkeit - der Strahlung der Laserdiode entlang der schnellen Achse höher als entlang der langsamen Achse.

Vorteilhaft sind nun die schnellen Achsen der Laserdioden parallel zur Längsachse der Pumpkammer ausgerichtet; zugleich sind die langsamen Achsen senkrecht zur Längsachse der Pumpkammer ausgerichtet. Dies führt zu einer sehr effizienten Homogenisierung der Strahlung, sodass die Strahlung mit sehr homogener Intensität in die Pumpkammer eingekoppelt werden kann. Dies wiederum bedingt eine äußerst effiziente Pumpwirkung in dem Lasermedium.

Gemäß einer Weiterbildung der Erfindung ist vorgesehen, dass die Einkoppelfläche mindestens so groß ist wie die Abstrahlfläche des Laserdiodenarrays. Auf diese Weise wird vorteilhaft gewährleistet, dass die Strahlung der Pumplichtquelle vollständig in das Lichtleitmedium eingekoppelt wird.

In einer Ausführungsform ist die Einkoppelfläche höchstens geringfügig größer als die Abstrahlfläche, insbesondere höchstens um 10 % größer. Auf diese Weise kann vorteilhaft eine besonders gute Homogenisierung der Strahlung gewährleistet werden.

Gemäß einer Weiterbildung der Erfindung ist vorgesehen, dass das keilförmige Lichtleitmedium derart angeordnet und eingerichtet ist, dass sich die konvergenten Seitenflächen entlang der langsamen Achsen der Laserdioden des Laserdiodenarrays gegenüberliegen. Auf diese Weise wird die Strahlung entlang der langsamen Achse durch die konvergenten, das heißt sich verjüngenden Seitenflächen des Lichtleitmediums reflektiert, wodurch eine äußerst effiziente Kollimation und Homogenisierung der Strahlung - in Richtung der langsamen Achse - erfolgt, sodass die Strahlung mit besonders homogener Intensität in die Pumpkammer eingekoppelt werden kann. Insbesondere auf diese Weise kann eine homogene und an den Durchmesser des Lasermediums angepasste, in Richtung der Längsachse linienförmige Pumpstrahlung erhalten werden.

Gemäß einer Weiterbildung der Erfindung ist vorgesehen, dass das Lichtleitmedium eine an eine im Betrieb der Pumpkammer im Inneren der Pumpkammer herrschende Brechzahl angepasste Brechzahl aufweist. Auf diese Weise können vorteilhaft Beugungsverluste, insbesondere Fresnelverluste, beim Eintritt in die Pumpkammer zumindest verringert, insbesondere minimiert oder vermieden werden. Weiterhin wird die Homogenisierung der Strahlung nicht durch Beugung beim Übergang in die Pumpkammer gestört.

In einer Ausführungsform ist die Brechzahl des Lichtleitmediums identisch zu der im Inneren der Pumpkammer herrschenden Brechzahl. Alternativ beträgt eine Abweichung zwischen den Brechzahlen höchstens 0,5, insbesondere höchstens 0,49, insbesondere höchstens 0,12.

Unter dem Betrieb der Pumpkammer in deren Inneren herrschenden Brechzahl wird in einer Ausgestaltung eine Brechzahl verstanden, die durch ein in der Pumpkammer vorhandenes, insbesondere die Pumpkammer durchströmendes Kühlmedium bestimmt ist, insbesondere die Brechzahl des Kühlmediums.

Gemäß einer Weiterbildung der Erfindung ist vorgesehen, dass ein Konvergenzwinkel, den die konvergenten Seitenflächen des Lichtleitmediums miteinander einschließen, derart auf die Strahlung der Pumplichtquelle abgestimmt ist, dass sich an den Seitenflächen Totalreflexion der Strahlung einstellt. Vorteilhaft wird auf diese Weise über die konvergenten Seitenflächen kein Pumplicht aus dem Lichtleitmedium ausgekoppelt, sodass keine Pumpleistung verloren geht. Zugleich wird vorteilhaft eine Erwärmung und gegebenenfalls Beschädigung oder sogar Zerstörung des Lichtleitmediums durch Restabsorption zumindest verringert, insbesondere minimiert oder vermieden, was andernfalls bei der - insbesondere ausschließlichen - Verwendung spiegelnder Flächen der Fall wäre. Insbesondere sind die konvergenten Seitenflächen derart ausgestaltet, das heißt insbesondere ist der Konvergenzwinkel derart abgestimmt, dass sich Mehrfachreflexionen der Strahlung der Pumplichtquelle an den Seitenflächen ergeben. Insbesondere auf diese Weise kann vorteilhaft eine sehr gute Homogenisierung des Pumplichts erhalten werden. Insbesondere kommt es bedingt durch die erzwungenen Mehrfachreflexionen in Richtung der langsamen Achsen zu einer starken Vermischung der Strahlen und somit zu einer Homogenisierung des Laserlichtes.

Es ist alternativ oder zusätzlich möglich, dass die Seitenflächen mit einer spiegelnden Schicht versehen sind.

In einer Ausführungsform ist der Konvergenzwinkel derart auf die Strahlung der Pumplichtquelle abgestimmt, dass - zusätzlich - eine Rückreflexion der Strahlung an den Seitenflächen in die Pumplichtquelle zumindest verringert, insbesondere minimiert oder vermieden wird. Vorteilhaft kann auf diese Weise eine Beschädigung der Pumplichtquelle durch deren eigene Strahlung verhindert werden.

Insbesondere ist der Konvergenzwinkel derart abgestimmt, dass sich einerseits an den Seitenflächen Totalreflexion, insbesondere Mehrfachreflexion, einstellt, wobei andererseits Rückreflexion vermieden wird.

Gemäß einer Weiterbildung der Erfindung ist vorgesehen, dass die Pumplichtführung eine Mehrzahl von entlang einer Umfangsrichtung der Pumpkammer zueinander versetzt angeordneten Pumpquellenhalterungen aufweist, wobei jeder Pumpquellenhalterung eine Lichtleitvorrichtung zugeordnet ist. Auf diese Weise kann besonders effizient eine hohe Pumplichtleistung in die Pumpkammer eingeleitet werden.

Insbesondere ist an jeder Pumpquellenhalterung eine - optional als Laserdiodenarray ausgebildete - Pumplichtquelle angeordnet. Alternativ oder zusätzlich ist jeder Pumpquellenhalterung eine Lichtleitvorrichtung zugeordnet.

Insbesondere sind die Pumpquellenhalterungen - und damit optional zugleich auch die Pumplichtquellen - entlang der Umfangsrichtung gleichverteilt um die Pumpkammer angeordnet, das heißt in gleichen Winkelabständen zueinander.

Unter einer Umfangsrichtung wird im Kontext der vorliegenden technischen Lehre eine Richtung verstanden, welche die Längsachse der Pumpkammer konzentrisch umgreift.

In einer Ausführungsform sind die Pumpquellenhalterungen derart zueinander versetzt angeordnet, dass sich keine zwei - jeweils an den Pumpquellenhalterungen angeordneten - Pumplichtquellen diametral gegenüberliegen. Vorteilhaft wird auf diese Weise eine Beeinträchtigung oder sogar Beschädigung einer Pumplichtquelle durch eine diametral gegenüberliegende Pumplichtquelle verhindert.

Unter "diametral" wird im Kontext der vorliegenden technischen Lehre insbesondere eine Ausrichtung entlang einer gedachten Durchmesserlinie der Pumpkammer verstanden, beziehungsweise anders ausgedrückt eine Ausrichtung entlang einer radialen Richtung, wobei die radiale Richtung senkrecht auf der Längsachse der Pumpkammer steht.

In einer Ausführungsform weist die Pumplichtführung eine ungerade Anzahl an Pumpquellenhalterungen auf. In einer Ausgestaltung weist die Pumplichtführung genau drei Pumpquellenhalterungen auf. In einer anderen Ausgestaltung weist die Pumplichtführung genau fünf Pumpquellenhalterungen auf. Diese Ausgestaltungen haben sich als besonders vorteilhaft erwiesen, insbesondere einerseits zur Erzeugung einer symmetrischen Pumplichtverteilung, andererseits zur Vermeidung sich diametral gegenüberliegender Pumplichtquellen.

Gemäß einer Weiterbildung der Erfindung ist vorgesehen, dass die Pumpkammer einen der mindestens einen Pumpquellenhalterung diametral gegenüberliegenden reflektierenden Wandungsbereich aufweist. Vorteilhaft kann auf diese Weise ein zumindest zweifacher Durchgang des Pumplichts durch das Lasermedium gewährleistet werden, wodurch dieses besonders effizient und homogen gepumpt wird. Bevorzugt ist jeder Pumpquellenhalterung ein solcher reflektierender Wandungsbereich zugeordnet.

Unter "reflektierend" wird im Kontext der vorliegenden technischen Lehre insbesondere eine spekular reflektierende oder eine diffus reflektierende Eigenschaft des Wandungsbereichs verstanden. Insbesondere kann der Wandungsbereich spiegelnde Eigenschaften aufweisen und/oder als Lambert-Streuer ausgebildet sein.

In einer Ausführungsform ist der Wandungsbereich zumindest bereichsweise gekrümmt, insbesondere derart, dass das von dem Wandungsbereich reflektierte Pumplicht in Richtung des Lasermediums gelenkt, insbesondere auf das Lasermedium fokussiert wird. Insbesondere kann der zumindest bereichsweise gekrümmte Wandungsbereich als Hohlspiegel ausgebildet sein oder als Hohlspiegel wirken. Dabei ist er bevorzugt derart ausgestaltet, dass das reflektierte Pumplicht auf das Lasermedium fokussiert wird. Es ist möglich, dass die Pumpkammer insgesamt kreiszylindrisch ausgebildet ist oder zumindest bereichsweise Abschnitte einer Kreiszylinder-Umfangsfläche als den mindestens einen Wandungsbereich aufweist.

In einer Ausgestaltung ist die Pumpkammer als hohler Kreiszylinder ausgebildet, bei dem für jedes Lichtleitmedium ein Zylindersegment entfernt ist, sodass sich zumindest eine gedachte ebene Kontaktfläche zwischen der Pumpkammer und dem Lichtleitmedium ergibt. Das Lichtleitmedium kann einteilig mit der Pumpkammer ausgebildet sein, wobei die Kontaktfläche in diesem Fall lediglich als gedachte Fläche vorliegt. Das Lichtleitmedium kann aber auch bündig an der Kontaktfläche anliegen, wobei die Kontaktfläche dann - als eine reale Anlagefläche - bevorzugt parallel zu der Einkoppelfläche orientiert ist.

Gemäß einer Weiterbildung der Erfindung ist vorgesehen, dass das keilförmige Lichtleitmedium zusätzlich zu den zwei konvergenten Seitenflächen zwei weitere, einander - insbesondere entlang der schnellen Achsen der Laserdioden - gegenüberliegende Grenzflächen aufweist, die zueinander parallel orientiert sind. Vorteilhaft wird auf diese Weise entlang der schnellen Achsen gewährleistet, dass der Winkel der Totalreflexion nicht überschritten wird, sodass eine Auskopplung von Pumplicht vermieden wird. Zugleich wird das Pumplicht bevorzugt auch entlang der schnellen Achsen fokussiert, weil eine Reflexion an den parallelen - und optional senkrecht zur Einkoppelfläche stehenden - Grenzflächen auftritt und der beleuchtete Bereich durch die Reflexion kleiner ist als wenn die Grenzflächen divergent wären und den gleichen Öffnungswinkel wie die schnellen Achsen hätten. Diese Fokussierung sorgt für einen definierten Bereich, in dem die Pumpstrahlung mit höherer Bestrahlungsstärke auf das Lasermedium trifft, als wenn in den schnellen Achsen keine Reflexion auftreten würde. Ohne Reflexion würde die Pumpstrahlung einen großen Bereich mit geringerer Bestrahlungsstärke beleuchten.

In einer Ausgestaltung stehen die Grenzflächen senkrecht auf der Einkoppelfläche.

Alternativ öffnen sich die einander gegenüberliegenden weiteren Grenzflächen in Richtung der Pumpkammer. Dies bedeutet insbesondere, dass die beiden Grenzflächen in Richtung der Pumpkammer auseinanderlaufen, das heißt divergent zueinander sind. Sie schließen dann mit der Einkoppelfläche jeweils einen Winkel ein, der größer ist als 90°. In einer Ausgestaltung ist dieser Winkel gleich oder leicht kleiner als der Öffnungswinkel der Strahlungsbündel entlang der schnellen Achsen der Laserdioden, um eine möglichst vollständige Ausleuchtung in dieser Dimension zu realisieren.

Es ist alternativ oder zusätzlich möglich, dass die Grenzflächen mit einer spiegelnden Schicht versehen sind.

Die Aufgabe wird in einem zweiten Aspekt insbesondere auch gelöst, indem eine Pumpvorrichtung zum optischen Pumpen eines Lasermediums geschaffen wird, insbesondere eine Pumpvorrichtung nach einer oder mehreren der zuvor beschriebenen Ausführungsformen, wobei die Pumpvorrichtung eine Pumpkammer zur Aufnahme des Lasermediums, eine Pumplichtführung zur Führung und Formung von Pumpstrahlung und eine Kühlmedienführung zur Führung eines Kühlmediums aufweist, wobei die Kühlmedienführung eingerichtet ist, um das Kühlmedium an zumindest eine Kühlstelle zu führen, die ausgewählt ist aus der Pumpkammer und mindestens einer Pumpquellenhalterung. Vorteilhaft wird auf diese Weise eine effiziente Kühlung des Lasermediums und/oder der mindestens einen Pumpquellenhalterung sowie zugleich ein effizientes Pumpen des Lasermediums gewährleistet.

In einer Ausführungsform ist die Pumpvorrichtung des zweiten Aspekts die Pumpvorrichtung gemäß dem ersten Aspekt, oder sie ist gemäß mindestens einer der oben beschriebenen Ausführungsformen des ersten Aspekts ausgestaltet. Entsprechend ist dann die Pumpkammer die bereits zuvor beschriebene Pumpkammer, die Pumplichtführung ist die bereits zuvor beschriebene Pumplichtführung, und die mindestens eine Pumpquellenhalterung ist die bereits zuvor beschriebene Pumpquellenhalterung. Hinzu tritt dann die in dieser Ausführungsform zusätzlich vorgesehene Kühlmedienführung.

Die Pumpkammer ist insbesondere eingerichtet zur Halterung und Kühlung des Lasermediums.

In einer Ausführungsform weist die Pumpkammer mindestens eine Kammer-Zufuhröffnung und mindestens eine Kammer-Abfuhröffnung für das Kühlmedium auf, sodass die Pumpkammer im Betrieb der Pumpvorrichtung von dem Kühlmedium durchströmt werden kann. Insbesondere wird das Lasermedium im Betrieb der Pumpvorrichtung von dem Kühlmedium umströmt. Optional weist die Pumpkammer zusätzlich mindestens ein Kammer-Strömungsleitelement auf, das angeordnet und eingerichtet ist, um die Kühlmedienströmung durch die Pumpkammer von der Kammer-Zufuhröffnung zu der Kammer-Abfuhröffnung zu leiten.

Alternativ oder zusätzlich weist die mindestens eine Pumpquellenhalterung mindestens eine Halterungs-Zufuhröffnung und mindestens eine Halterungs-Abfuhröffnung für das Kühlmedium auf, sodass die Pumpquellenhalterung im Betrieb der Pumpvorrichtung von dem Kühlmedium durchströmt werden kann. Weiterhin weist die Pumpquellenhalterung optional mindestens eine Lichtquellen-Zufuhröffnung und mindestens eine Lichtquellen-Abfuhröffnung für das Kühlmedium auf, sodass das Kühlmedium von der Pumpquellenhalterung in die an der Pumpquellenhalterung angeordneten Pumplichtquelle und zurück von der Pumplichtquelle in die Pumpquellenhalterung strömen kann. Die Pumpquellenhalterung kann zusätzlich mindestens ein Halterungs-Strömungsleitelement aufweisen, das angeordnet und eingerichtet ist, um die Kühlmedienströmung durch die Pumpquellenhalterung von der Halterungs-Zufuhröffnung zu der Halterungs-Abfuhröffnung - und optional durch die Pumplichtquelle - zu leiten.

In einer Ausführungsform weist die Kühlmedienführung einen ersten Kühlkreislauf zur Kühlung der mindestens einen Pumpquellenhalterung - und mittelbar oder unmittelbar der mindestens einen Pumplichtquelle - und einen zweiten Kühlkreislauf zur Kühlung der Pumpkammer - und damit des Lasermediums - auf.

In einer anderen Ausführungsform weist die Kühlmedienführung einen gemeinsamen Kühlkreislauf zur Kühlung der mindestens einen Pumpquellenhalterung - und mittelbar oder unmittelbar der mindestens einen Pumplichtquelle - und zur Kühlung der Pumpkammer - und damit des Lasermediums - auf. Der gemeinsame Kühlkreislauf weist insbesondere einen globalen Kühlmedien-Zulauf und einen globalen Kühlmedien-Ablauf auf, wobei ein Strömungspfad des gemeinsamen Kühlkreislaufs für das Kühlmedium zwischen dem globalen Kühlmedien-Zulauf und dem globalen Kühlmedien-Ablauf durch die mindestens eine Pumpquellenhalterung - optional durch die Pumplichtquelle - und durch die Pumpkammer führt.

In einer Ausgestaltung sind dabei die mindestens eine Pumpquellenhalterung und die Pumpkammer hintereinander strömungstechnisch in Reihe angeordnet, wobei das Kühlmedium optional ausgehend von dem globalen Kühlmedien-Zulauf zuerst durch die mindestens eine Pumpquellenhalterung und danach durch die Pumpkammer strömt, bevor es von der Pumpkammer zu dem globalen Kühlmedien-Ablauf strömt.

Weist die Pumpvorrichtung eine Mehrzahl an Pumpquellenhalterungen auf, sind diese bevorzugt in dem gemeinsamen Kühlkreislauf zueinander strömungstechnisch parallel angeordnet, sodass das Kühlmedium ausgehend von dem globalen Kühlmedien-Zulauf auf die verschiedenen Pumpquellenhalterungen verzweigt und stromaufwärts der Pumpkammer wieder von den verschiedenen Pumpquellenhalterungen her zusammengeführt und der Pumpkammer gesammelt zugeführt wird, bevor es zu dem globalen Kühlmedien-Ablauf strömt.

Gemäß einer Weiterbildung der Erfindung ist vorgesehen, dass die mindestens eine Pumpquellenhalterung eingerichtet ist, um Wärme von einer an der Pumpquellenhalterung angeordneten Pumplichtquelle abzuführen. Auf diese Weise kann besonders effizient - insbesondere zusätzlich oder auch alternativ zu einer Kühlung mit dem Kühlmedium - Wärme von der Pumpquellenhalterung und damit auch mittelbar von der daran angeordneten Pumplichtquelle abgeführt werden.

In einer Ausgestaltung ist die mindestens eine Pumpquellenhalterung geometrisch derart ausgebildet, dass die Wärme der Pumplichtquelle über die Pumpquellenenhalterung abgeführt werden kann, insbesondere indem die Pumpquellenhalterung eine vergrößerte oder strukturierte Abstrahlfläche, beispielsweise mit Kühlrippen oder dergleichen, aufweist. Alternativ oder zusätzlich kann die Pumpquellenhalterung eine geeignet ausgestaltete Auflagefläche für die Pumplichtquelle oder eine geeignet gestaltete Innenstrukturierung aufweisen.

Weiter alternativ oder zusätzlich ist die mindestens eine Pumpquellenhalterung Teil des mindestens einen Kühlkreislaufs, wobei sie insbesondere eingerichtet sein kann, um das Kühlmedium in die an der Pumpquellenhalterung angeordnete Pumplichtquelle einzuleiten.

In einer Ausführungsform ist die Kühlmedienführung eingerichtet, um die mindestens eine Pumpquellenhalterung zu halten. Alternativ oder zusätzlich ist die mindestens eine Pumpquellenhalterung an der Kühlmedienführung angeordnet, insbesondere an dieser befestigt oder einteilig mit dieser ausgebildet. In einer Ausgestaltung bildet die Kühlmedienführung einen Grundkörper der Pumpvorrichtung, an der die mindestens eine Pumpquellenhalterung - und optional auch die Pumpkammer und/oder die Pumplichtführung, insbesondere die mindestens eine Lichtleitvorrichtung - angeordnet sind, wobei diese Elemente optional aneinander befestigt oder einteilig miteinander ausgebildet sein können. Insbesondere weist die als Grundkörper ausgebildete Kühlmedienführung mindestens eine Halterung für die Pumpkammer und/oder die Pumplichtführung auf.

Gemäß einer Weiterbildung der Erfindung ist vorgesehen, dass mindestens zwei Komponenten, ausgewählt aus der Gruppe bestehend aus der Pumpkammer, der Pumpquellenhalterung, der Kühlmedienführung, der Pumplichtführung, der Lichtleitvorrichtung, dem Lichtleitmedium, dem transparenten Volumenkörper, und einer Kombination der genannten Komponenten, miteinander einstückig ausgebildet sind.

In einer Ausgestaltung sind die mindestens zwei Komponenten materialeinheitlich ausgebildet, das heißt sie weisen ein gemeinsames Material auf, oder sie bestehen aus demselben, gemeinsamen Material.

In einer Ausführungsform sind die mindestens zwei Komponenten einstückig - insbesondere durch Urformen, Umformen oder Trennen, insbesondere Schleifen - gefertigt. Alternativ sind die mindestens zwei Komponenten miteinander gefügt, insbesondere durch Kleben, Schweißen, insbesondere Diffusionsschweißen, oder Ansprengen, wobei "Ansprengen" im Kontext der vorliegenden technischen Lehre insbesondere das Verbinden von zwei geschliffenen, polierten und gereinigten Flächen hoher Paßgenauigkeit durch Adhäsion meint. Bevorzugt ist eine Fügestelle zwischen den mindestens zwei Komponenten, insbesondere zwischen dem Lichtleitmedium und der Pumpkammer, für das Pumplicht optisch transparent ausgebildet und bevorzugt an die Brechzahl der Fügepartner angepasst.

In einer Ausführungsform wird zumindest das Lichtleitmedium, das heißt insbesondere der transparente Volumenkörper, - oder das einstückige Bauteil aus den mindestens zwei Komponenten - in einem additiven Verfahren oder in einem Sol-Gel-Verfahren hergestellt, insbesondere nach einem Trockenschritt gesintert und/oder gebrannt.

In einer Ausgestaltung sind die mindestens zwei Komponenten für das Pumplicht transparent ausgebildet. Insbesondere weisen die mindestens zwei Komponenten ein Material auf oder bestehen aus einem Material, das ausgewählt ist aus einer Gruppe, bestehend aus Quarz, Quarzglas, Glas, Kunststoff, und einer Kombination aus wenigstens zwei der genannten Materialien. Insbesondere ist das Material transparent bei 790 nm.

In einer Ausführungsform sind die mindestens zwei Komponenten die Pumpkammer und das mindestens eine Lichtleitmedium. Insbesondere sind die mindestens zwei Komponenten die Pumpkammer und der mindestens eine transparente Volumenkörper. Insbesondere diese beiden Komponenten sind bevorzugt miteinander einteilig ausgebildet oder in optisch transparenter Weise gefügt. Bevorzugt sind die beiden Komponenten miteinander materialeinheitlich, vorzugsweise aus mindestens einem der genannten Materialien, insbesondere aus Quarzglas, ausgebildet.

Alternativ oder zusätzlich sind mindestens zwei Komponenten die Kühlmedienführung und die mindestens eine Pumpquellenhalterung. In einer Ausführungsform sind diese beiden Komponenten miteinander materialeinheitlich ausgebildet, beispielsweise durch Spritzgießen oder in einem additiven Verfahren hergestellt, insbesondere durch 3D-Druck, beispielsweise Lasersintern oder Laserschmelzen. Insbesondere in einem additiven Verfahren können auf sehr einfachem Weg neben einer Positionierung und Fixierung der Komponenten auch besonders geeignete Ausgestaltungen der Kühlmedienführung realisiert werden.

Ist die mindestens ein Pumpquellenhalterung aktiv gekühlt und Teil des mindestens einen Kühlmedienkreislaufs, können die Komponenten Kunststoff aufweisen oder aus Kunststoff bestehen; ist die Pumpquellenhalterung dagegen passiv gekühlt, weisen die Komponenten optional ein gut wärmeleitendes Material auf oder bestehen aus diesem, insbesondere Metall, beispielsweise Kupfer.

Allgemein weist in einer Ausführungsform die mindestens eine Pumpquellenhalterung Kunststoff oder ein Metall, insbesondere Kupfer, auf, oder sie besteht aus einem dieser Werkstoffe.

Gemäß einer Weiterbildung der Erfindung ist vorgesehen, dass in der Pumpkammer ein Kühlmedium angeordnet ist, das eine an eine Brechzahl des Lichtleitmediums angepasste Brechzahl aufweist.

Insbesondere ist in der Kühlmedienführung ein Kühlmedium angeordnet, das eine an eine Brechzahl des Lichtleitmediums angepasste Brechzahl aufweist.

Dass das Kühlmedium in der Pumpkammer oder in der Kühlmedienführung angeordnet ist, bedeutet im Kontext der vorliegenden technischen Lehre insbesondere, dass es im Betrieb der Pumpvorrichtung darin strömt.

Vorzugsweise weist das Kühlmedium eine zu dem Lichtleitmedium identische Brechzahl auf. Alternativ beträgt eine Abweichung zwischen den Brechzahlen höchstens 0,5, insbesondere höchstens 0,49, insbesondere höchstens 0,12.

In einer Ausführungsform ist das Kühlmedium Wasser.

Alternativ oder zusätzlich weist das Kühlmedium mindestens ein Additiv auf, beispielsweise einen Biofilm-Inhibitor oder ein Korrosionsschutzmittel.

Die Aufgabe wird in einem dritten Aspekt insbesondere auch gelöst, indem eine Laseranordnung geschaffen wird, die ein Lasermedium und mindestens eine erfindungsgemäße Pumpvorrichtung - nach dem ersten oder zweiten Aspekt -, oder eine Pumpvorrichtung nach einer oder mehreren der zuvor beschriebenen Ausführungsformen - wiederum nach dem ersten oder zweiten Aspekt - aufweist. In Zusammenhang mit der Laseranordnung ergeben sich insbesondere diejenigen Vorteile, die zuvor bereits in Zusammenhang mit der Pumpvorrichtung erläutert wurden.

Gemäß einer Weiterbildung der Erfindung ist vorgesehen, dass als die mindestens eine Pumpvorrichtung eine Mehrzahl an Pumpvorrichtungen entlang der Längsachsen ihrer Pumpkammern nebeneinander angeordnet sind. Auf diese Weise kann eine besonders leistungsstarke und effiziente Pumpwirkung - insbesondere bei gleichzeitig effizienter Kühlung - auch für ein in Längsrichtung ausgedehntes Lasermedium erzielt werden.

Insbesondere sind die Pumpvorrichtungen entlang der Längsachsen ihrer Pumpkammern hintereinander, das heißt gleichsam geometrisch in Reihe, angeordnet. In einer Ausgestaltung sind die Pumpvorrichtungen zusätzlich bezüglich ihrer Kühlmedienkreisläufe strömungstechnisch miteinander in Reihe geschaltet. Es ist jedoch auch möglich, dass die einzelnen Pumpvorrichtungen voneinander separate Kühlmedienkreisläufe aufweisen.

In vorteilhaften Ausführungsformen wird die Lichtleitvorrichtung, insbesondere der transparente Volumenkörper, aus Quarz bzw. Quarzglas gefertigt, wie oben bereits ausgeführt. Die Herstellung kann durch klassische spanende bzw. trennende und formgebende Verfahren erfolgen, z. B. Sägen, Schleifen, Fräsen, Läppen und Polieren, wobei optische Funktionsflächen (Einkoppelfläche, konvergente Seitenflächen) auf die für Totalreflexion und geringe Streuung erforderliche Ebenheit und Rauheit endbearbeitet werden. Alternativ oder zusätzlich kann der Volumenkörper durch Aufschichtung mehrerer Quarzscheiben/-platten erzeugt werden, die nach einer Vorformgebung aneinander positioniert und durch Diffusionsschweißen stoffschlüssig gefügt werden, gefolgt von einer optionalen Endpolitur zur Erzielung optischer Qualität der Grenzflächen. Die Aufschichtung erlaubt eine präzise Abbildung der keilförmigen Geometrie und die Anpassung des Konvergenzwinkels der Seitenflächen an die Pumpstrahlung, etwa zur Gewährleistung der Totalreflexion und zur Reduktion von Rückreflexionen in Richtung der Pumpquelle.

Diese Herstellungsvarianten sind unabhängig von der konkreten Materialwahl (innerhalb der vorstehend genannten transparenten Materialien) einsetzbar und skalierbar für verschiedene Querschnitte und Längen der Lichtleitvorrichtung.

In möglichen Ausführungsformen werden der transparente Volumenkörper der Lichtleitvorrichtung und die Pumpkammer als Einzelteile gefertigt und anschließend gefügt. Das Fügen kann dabei insbesondere durch:
- Diffusionsschweißen (glas-/quarztypisches Festphasenfügen geeigneter, gereinigter und planparalleler Fügeflächen),
- Laserschweißen (lokal oder umlaufend; insbesondere für hermetische, glasklare Verbindungen zwischen Glas-/Quarz-Bauteilen),
- Kleben (z. B. mit optisch transparenten, index-angepassten Klebstoffen), oder
- Ansprengen im Sinne hochpräziser Adhäsionsverbindungen planpolierter Oberflächen erfolgen.

Die Wahl des Fügeverfahrens kann anhand optischer Anforderungen (Transmission, Streuung, Absorption), thermischer Randbedingungen (Wärmeeintrag, Wärmeleitpfad zur Kühlung), mechanischer Kriterien (Festigkeit, Hermetizität, Vibrationsfestigkeit) sowie Service-Aspekten (Demontierbarkeit, Austauschbarkeit) erfolgen. Für die optische Funktion ist bevorzugt, dass die Fügestelle hinsichtlich Brechzahl und Dispersion an die Fügepartner angepasst ist und die Oberflächenformgenauigkeit beibehält, sodass die optische Durchgängigkeit bis unmittelbar zur Pumpkammer gewahrt bleibt und Fresnelverluste minimiert werden.

Mechanisch können die Fügeflächen als plane Anlageflächen (z. B. Abflachungen an einer ansonsten kreiszylindrischen Pumpkammer) ausgebildet werden, an denen der transparente Volumenkörper bündig, d. h. spaltfrei, anliegt. Toleranzkonzepte berücksichtigen thermische Ausdehnungskoeffizienten der beteiligten Materialien und die Ankopplung an die Kühlmedienführung, um Verspannungen und Dejustagen unter Betriebsbedingungen zu vermeiden.Die Erfindung wird im Folgenden anhand der Zeichnung näher erläutert. Dabei zeigen:
- Figur 1: eine dreidimensionale Darstellung eines Ausführungsbeispiels einer Laseranordnung mit einem Ausführungsbeispiel einer Pumpvorrichtung;
- Figur 2: eine Draufsicht entlang einer Längsachse auf das Ausführungsbeispiel der Laseranordnung gemäß Fig. 1;
- Figur 3: eine Seitenansicht des Ausführungsbeispiels der Laseranordnung gemäß Fig. 1;
- Figur 4: eine erste Detaildarstellung eines Ausführungsbeispiels einer Pumpvorrichtung, und
- Figur 5: eine zweite Detaildarstellung eines Ausführungsbeispiels einer Pumpvorrichtung.

**Fig**. **1** zeigt eine dreidimensionale Darstellung eines Ausführungsbeispiels einer Laseranordnung 1 mit einem Ausführungsbeispiel einer Pumpvorrichtung 3.

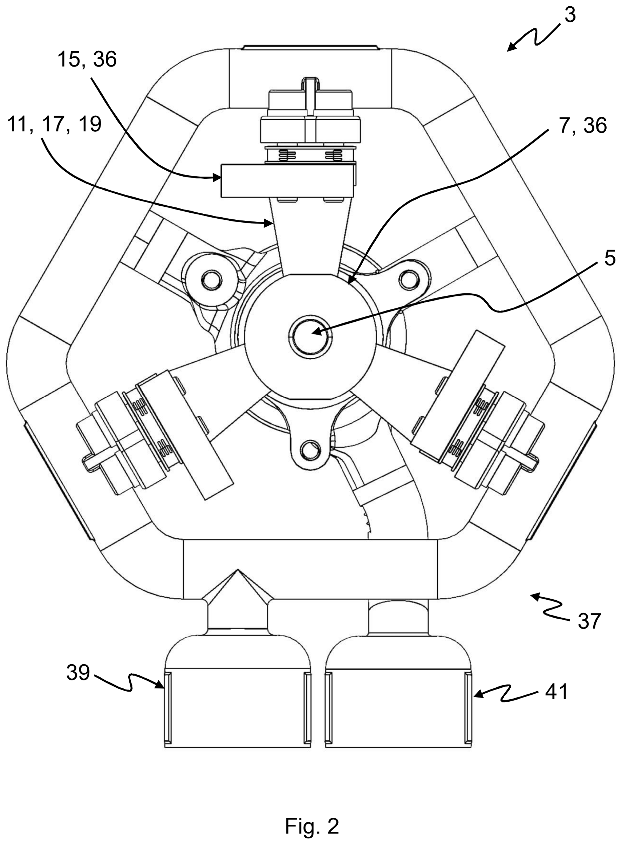

Mehrfach vorhandene Elemente sind in den Figuren der besseren Übersichtlichkeit wegen in der Regel nur einmal mit einem Bezugszeichen versehen. Außerdem sind gleiche und funktionsgleiche Elemente in allen Figuren stets mit gleichen Bezugszeichen versehen, sodass ab Figur 2 insofern jeweils auf die vorangegangene Beschreibung verwiesen wird.

Die Laseranordnung weist die Pumpvorrichtung 3 und ein Lasermedium 5 auf. Die Pumpvorrichtung 3 weist eine Pumpkammer 7 auf, in der das Lasermedium 5 angeordnet ist.

Es ist in hier nicht dargestellter Weise möglich, dass eine Mehrzahl solcher Pumpvorrichtungen 3 entlang einer Längsachse L des Lasermediums 5 und damit zugleich entlang der Längsachsen ihrer Pumpkammern 7, die mit der Längsachse L zusammenfallen, neben- oder hintereinander angeordnet sind.

Die Pumpvorrichtung 3 weist außerdem eine Pumplichtführung 9 auf, die mindestens eine Lichtleitvorrichtung 11 - hier drei entlang der Umfangsrichtung gleichverteilt um die Längsachse L, das heißt in gleichen Winkelabständen zueinander angeordnete Lichtleitvorrichtungen 11 - aufweist, die sich von jeweils einer zur Halterung einer mindestens eine Laserdiode aufweisenden Pumplichtquelle 13 eingerichteten Pumpquellenhalterung 15 bis unmittelbar zu der Pumpkammer 7 erstreckt. Die Lichtleitvorrichtungen 11 weisen jeweils ein als für die Strahlung der Pumplichtquellen 13 transparenter Volumenkörper 17 ausgebildetes Lichtleitmedium 19 auf, wobei die Lichtleitmedien 19 jeweils im Bereich der zugeordneten Pumpquellenhalterung 15 eine Einkoppelfläche 21 aufweisen. Die Einkoppelflächen 21 sind derart ausgebildet, dass die Strahlung der Pumplichtquellen 13 in die Lichtleitvorrichtungen 11 eingekoppelt werden kann, wenn die jeweilige Pumplichtquelle 13 an der ihr zugeordneten Pumpquellenhalterung 15 angeordnet ist. Das Lichtleitmedium 19, das heißt der transparente Volumenkörper 17, ist keilförmig ausgebildet, mit zwei konvergenten Seitenflächen 23, die sich jeweils in einer gedachten Ebene, die senkrecht auf der Längsachse L steht, in Richtung der Pumpkammer 7 einander annähern.

Die Lichtleitvorrichtung 11, insbesondere das Lichtleitmedium 19, insbesondere der transparente Volumenkörper 17, grenzt unmittelbar an die Pumpkammer 7 an, das heißt zwischen der Pumpkammer 7 und dem transparenten Volumenkörper 17 ist kein Luftspalt und auch kein anderes Medium vorhanden. Alternativ ist das Lichtleitmedium 19, insbesondere der transparente Volumenkörper 17, einteilig, insbesondere materialeinheitlich, mit der Pumpkammer 7 ausgebildet.

Die Einkoppelflächen 21 sind bevorzugt ebene Flächen, die insbesondere jeweils parallel zu einer Abstrahlfläche 25 der jeweiligen Pumplichtquelle 13 angeordnet ist. Zwischen der jeweiligen Einkoppelfläche 21 und der Abstrahlfläche 25 ist bevorzugt ein Spalt, insbesondere ein Luftspalt, angeordnet. Dieser Spalt ist vorzugsweise der einzige Spalt zwischen der Abstrahlfläche 25 und der Pumpkammer 7, insbesondere der einzige Medienspalt oder Luftspalt, so dass die Anzahl der Grenzflächen für das Pumplicht gering ist. Die Einkoppelflächen 21 können eine Antireflexbeschichtung aufweisen. Die Einkoppelflächen 21 sind bevorzugt jeweils mindestens so groß wie - oder höchstens geringfügig größer als - die jeweils zugeordnete Abstrahlfläche 25, insbesondere höchstens um 10 % größer.

Das Lasermedium 5 ist bevorzugt ein Festkörper, insbesondere ein Laserstab 27. Es kann aber auch als Laserscheibe ausgebildet sein.

An den Pumpquellenhalterungen 15 ist bevorzugt jeweils ein Laserdiodenarray 29 als Pumplichtquelle 13 angeordnet. Dabei sind die Pumpquellenhalterungen 15 und das jeweilige Lichtleitmedium 19 derart eingerichtet und aufeinander abgestimmt, dass schnelle Achsen der Laserdioden der Laserdiodenarrays 29 parallel zu der Längsachse L ausgerichtet sind. Insbesondere sind die Laserdiodenarrays 29 und das jeweils zugeordnete Lichtleitmedium 19 derart relativ zueinander angeordnet, dass die schnellen Achsen parallel zu der Längsachse L ausgerichtet sind. Zugleich sind die langsamen Achsen der Laserdioden senkrecht zur Längsachse L ausgerichtet.

Die keilförmigen Lichtleitmedien 19 sind derart angeordnet und eingerichtet, dass sich die konvergenten Seitenflächen 23 jeweils entlang der langsamen Achsen der Laserdiodenarrays 29 gegenüberliegen.

Insbesondere erstrecken sich die Lichtleitmedien 19 durchgehend zwischen der jeweiligen Pumpquellenhalterung 15 und der Pumpkammer 7, insbesondere durchgehend einstückig oder zumindest ohne weitere optische Grenzfläche über die Einkoppelfläche 21 hinaus. Dies kann auch so bezeichnet werden, dass sich die Lichtleitmedien 19 optisch durchgehend zwischen der jeweiligen Pumpquellenhalterung 15 und der Pumpkammer 7 erstrecken.

Ein Konvergenzwinkel, den die konvergenten Seitenflächen 23 miteinander einschließen, ist bevorzugt derart auf die Strahlung der Pumplichtquellen 13 abgestimmt, dass sich an den Seitenflächen 23 Totalreflexion einstellt. Insbesondere ist der Konvergenzwinkel derart abgestimmt, dass sich Mehrfachreflexionen der Strahlung an den Seitenflächen 23 ergeben. Bevorzugt ist der Konvergenzwinkel derart auf die Strahlung der Pumplichtquellen 13 abgestimmt, dass außerdem eine Rückreflexion der Strahlung an den Seitenflächen 23 in die Pumplichtquellen 13 vermieden wird.

Bevorzugt sind die Pumpquellenhalterungen 15 derart zueinander versetzt angeordnet, dass sich keine zwei Pumplichtquellen 13 diametral gegenüberliegen.

Die Pumpkammer 7 weist bevorzugt jeweils einen den Pumpquellenhalterungen 15 diametral gegenüberliegenden, spekular und/oder diffusiv reflektierenden Wandungsbereich 31 auf. Vorzugsweise ist der Wandungsbereich 31 zumindest bereichsweise gekrümmt, insbesondere derart, dass das von dem Wandungsbereich 31 reflektierte Pumplicht in Richtung des Lasermediums 5 gelenkt, insbesondere auf das Lasermedium 5 fokussiert wird.

Das keilförmige Lichtleitmedium 19 weist bevorzugt zusätzlich zu den zwei konvergenten Seitenflächen 23 zwei weitere, einander - insbesondere entlang der schnellen Achsen der Laserdioden - gegenüberliegende Grenzflächen 33 auf, die zueinander parallel orientiert sind. Insbesondere stehen die weiteren Grenzflächen 33 senkrecht auf der Einkoppelfläche 21. Alternativ öffnen sich die weiteren Grenzflächen 33 in Richtung der Pumpkammer 7.

Die Pumpvorrichtung 3 weist hier außerdem eine Kühlmedienführung 35 zur Führung eines Kühlmediums auf, wobei die Kühlmedienführung 35 eingerichtet ist, um das Kühlmedium an zumindest eine Kühlstelle 36 zu führen, die ausgewählt ist aus der Pumpkammer 7 und der mindestens einen Pumpquellenhalterung 15. Die Pumpkammer 7 ist insbesondere eingerichtet zur Halterung und Kühlung des Lasermediums 5.

Vorzugsweise sind mindestens zwei Komponenten, ausgewählt aus der Gruppe bestehend aus der Pumpkammer 7, der Pumpquellenhalterung 15, der Kühlmedienführung 35, der Pumplichtführung 9, der Lichtleitvorrichtung 11, dem Lichtleitmedium 19, dem transparenten Volumenkörper 17, und einer Kombination der genannten Komponenten, miteinander einstückig, ausgebildet. Insbesondere sind die mindestens zwei Komponenten miteinander materialeinheitlich ausgebildet, das heißt sie weisen ein gemeinsames Material auf, oder sie bestehen aus demselben, gemeinsamen Material. Es ist möglich, dass die mindestens zwei Komponenten einstückig - insbesondere durch Urformen, Umformen oder Trennen, insbesondere Schleifen - gefertigt sind. Alternativ sind die mindestens zwei Komponenten miteinander gefügt, insbesondere durch Kleben, Schweißen, insbesondere Diffusionsschweißen, oder Ansprengen.

Bevorzugt ist eine Fügestelle zwischen den mindestens zwei Komponenten, insbesondere zwischen dem Lichtleitmedium 19 - bzw. dem transparenten Volumenkörper 17 - und der Pumpkammer 7, für das Pumplicht optisch transparent ausgebildet. In einer Ausgestaltung sind die mindestens zwei Komponenten, insbesondere das Lichtleitmedium 19 - bzw. der transparente Volumenkörper 17 - und die Pumpkammer 7, für das Pumplicht transparent ausgebildet. Insbesondere weisen die mindestens zwei Komponenten, insbesondere das Lichtleitmedium 19 - bzw. der transparente Volumenkörper 17 - und die Pumpkammer 7, ein Material auf oder bestehen aus einem Material, das ausgewählt ist aus einer Gruppe, bestehend aus Quarz, Quarzglas, Glas, Kunststoff, und einer Kombination aus wenigstens zwei der genannten Materialien. Insbesondere ist das Material transparent bei 790 nm.

Vorzugsweise sind die mindestens zwei Komponenten die Pumpkammer 7 und der transparente Volumenkörper 17. Diese beiden Komponenten sind bevorzugt miteinander einteilig ausgebildet oder in optisch transparenter Weise gefügt. Besonders bevorzugt sind die beiden Komponenten miteinander materialeinheitlich, vorzugsweise aus mindestens einem der zuvor genannten Materialien, insbesondere aus Quarzglas, ausgebildet.

Vorzugsweise ist der transparente Volumenkörper 17, - oder das einstückige Bauteil aus den mindestens zwei Komponenten - in einem Sol-Gel-Verfahren hergestellt, insbesondere nach einem Trockenschritt gesintert und/oder gebrannt.

Bevorzugt sind die Kühlmedienführung 35 und die Pumpquellenhalterungen 15 die mindestens zwei Komponenten, daher miteinander einstückig und optional materialeinheitlich - aus Metall oder Kunststoff - ausgebildet, beispielsweise hergestellt durch Spritzgießen oder in einem additiven Verfahren, insbesondere durch 3D-Druck, beispielsweise Lasersintern oder Laserschmelzen.

Die Kühlmedienführung 35 bildet bevorzugt einen Grundkörper der Pumpvorrichtung 3, an der die mindestens eine Pumpquellenhalterung 15 - und optional auch die Pumpkammer 7 und die Pumplichtführung 9, insbesondere die mindestens eine Lichtleitvorrichtung 19 - angeordnet sind.

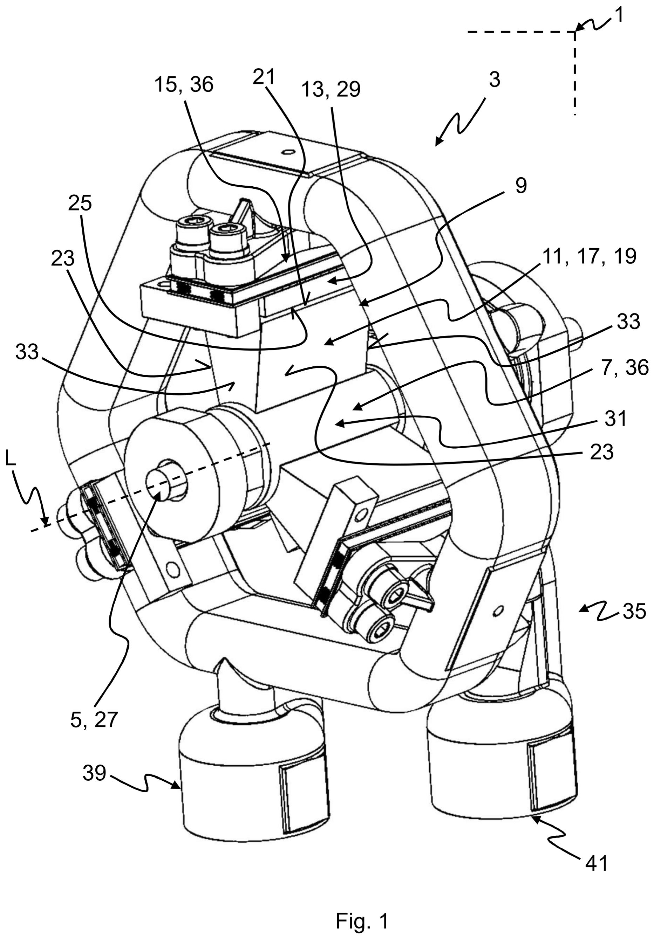

**Fig. 2** zeigt eine Draufsicht entlang der Längsachse L auf das Ausführungsbeispiel der Laseranordnung 1 gemäß Fig. 1.

Bei dem hier dargestellten Ausführungsbeispiel weist die Kühlmedienführung 35 einen gemeinsamen Kühlkreislauf 37 zur Kühlung der Pumpquellenhalterungen 15 - und mittelbar oder unmittelbar der Pumplichtquellen 13 - und zur Kühlung der Pumpkammer 7 - und damit des Lasermediums 5 - auf. Der gemeinsame Kühlkreislauf 37 weist insbesondere einen globalen Kühlmedien-Zulauf 39 und einen globalen Kühlmedien-Ablauf 41 auf, wobei ein Strömungspfad des gemeinsamen Kühlkreislaufs 37 für das Kühlmedium zwischen dem globalen Kühlmedien-Zulauf 39 und dem globalen Kühlmedien-Ablauf 41 durch die Pumpquellenhalterungen 15 - vorzugsweise auch durch die Pumplichtquellen 13 - und durch die Pumpkammer 7 führt. Dabei sind die Pumpquellenhalterungen 15 und die Pumpkammer 7 insbesondere hintereinander strömungstechnisch in Reihe angeordnet, wobei das Kühlmedium ausgehend von dem globalen Kühlmedien-Zulauf 39 zuerst durch die Pumpquellenhalterungen 15 und danach durch die Pumpkammer 7 strömt, bevor es von der Pumpkammer 7 zu dem globalen Kühlmedien-Ablauf 41 strömt. Die Pumpquellenhalterungen 15 sind bevorzugt strömungstechnisch zueinander parallel angeordnet, sodass das Kühlmedium ausgehend von dem globalen Kühlmedien-Zulauf 39 zunächst auf die verschiedenen Pumpquellenhalterungen 15 verzweigt und dann stromaufwärts der Pumpkammer 7 wieder von den Pumpquellenhalterungen 15 her zusammengeführt und der Pumpkammer 7 gesammelt zugeführt wird, bevor es zu dem globalen Kühlmedien-Ablauf 41 strömt.

Alternativ kann die Kühlmedienführung 35 aber auch einen ersten Kühlkreislauf zur Kühlung der Pumpquellenhalterungen 15 - und mittelbar oder unmittelbar der Pumplichtquellen 13 - und einen zweiten Kühlkreislauf zur Kühlung der Pumpkammer 7 - und damit des Lasermediums 5 - aufweisen.

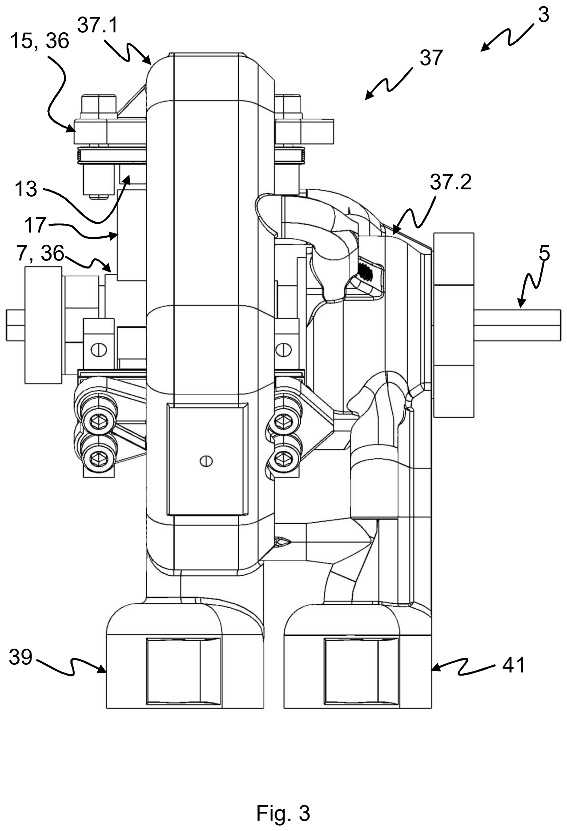

**Fig. 3** zeigt eine Seitenansicht des Ausführungsbeispiels der Laseranordnung 1 gemäß Fig. 1.

Der gemeinsame Kühlkreislauf 37 weist bevorzugt einen ersten Kreislauf-Abschnitt 37.1 auf, entlang dem das Kühlmedium von dem globalen Kühlmedien-Zulauf 39 zu den Pumpquellenhalterungen 15 strömt und insbesondere auf diese verzweigt wird. Er weist außerdem einen zweiten Kreislauf-Abschnitt 37.2 auf, entlang dem das Kühlmedium von den Pumpquellenhalterungen 15 her kommend gesammelt und der Pumpkammer 7 zugeführt wird, bevor es durch den globalen Kühlmedien-Ablauf 41 aussströmt.

Die Pumpquellenhalterungen 15 sind insbesondere eingerichtet, um Wärme mittelbar oder unmittelbar von den Pumplichtquellen 13 abzuführen. Bevorzugt sind die Pumpquellenhalterungen 15 Teil des gemeinsamen Kühlkreislaufs 37 oder des ersten Kühlkreislaufs. Die Pumpquellenhalterungen 15 können alternativ oder zusätzlich geometrisch derart ausgebildet sein, dass sie eine vergrößerte oder strukturierte Abstrahlfläche, beispielsweise mit Kühlrippen oder dergleichen, aufweisen. Alternativ oder zusätzlich können die Pumpquellenhalterungen 15 eine geeignet ausgestaltete Auflagefläche für die Pumplichtquellen 13 oder eine geeignet gestaltete Innenstrukturierung aufweisen.

Die Pumpquellenhalterungen 15 weisen bevorzugt jeweils eine nicht dargestellte Halterungs-Zufuhröffnung und eine nicht dargestellte Halterungs-Abfuhröffnung für das Kühlmedium auf, sodass die Pumpquellenhalterungen 15 im Betrieb der Pumpvorrichtung 3 von dem Kühlmedium durchströmt werden. Es ist möglich, dass die Pumpquellenhalterungen außerdem jeweils eine nicht dargestellte Lichtquellen-Zufuhröffnung und eine nicht dargestellte Lichtquellen-Abfuhröffnung für das Kühlmedium aufweisen, sodass das Kühlmedium von der jeweiligen Pumpquellenhalterung 15 in die dort angeordnete Pumplichtquelle 13 und zurückströmen kann.

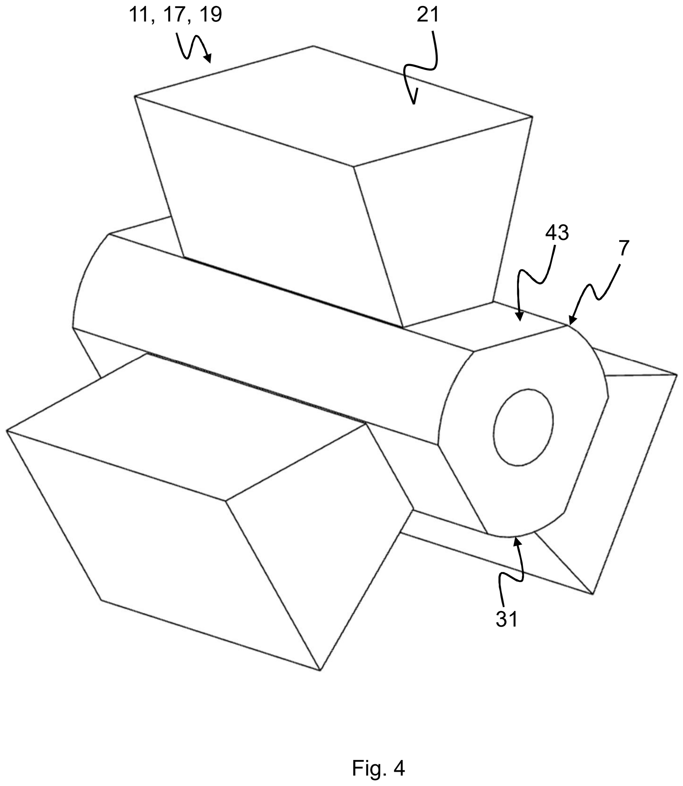

**Fig. 4** zeigt eine erste Detaildarstellung eines Ausführungsbeispiels einer Pumpvorrichtung 3.

Bei diesem Ausführungsbeispiel, bei dem die Pumpkammer 7 nicht einteilig mit den Lichtleitmedien 19 ausgebildet ist, weist die Pumpkammer 7 Anlageflächen 43 auf, insbesondere in Form von Abflachungen, an denen die transparenten Volumenkörper 17 bündig, das heißt ohne Spalt, anliegen.

Die Pumpkammer 7 weist bevorzugt bereichsweise Abschnitte einer Kreiszylinder-Umfangsfläche als den mindestens einen Wandungsbereich 31 auf, der damit bevorzugt als Hohlspiegel ausgebildet ist oder als Hohlspiegel wirkt. Dabei ist die Pumpkammer 7 als ein hohler Kreiszylinder ausgebildet, bei dem für jedes Lichtleitmedium 19 ein Zylindersegment entfernt ist, sodass sich die ebenen Anlageflächen 43 als Kontaktflächen zwischen der Pumpkammer 7 und den Lichtleitmedien 19 ergeben. Die transparenten Volumenkörper 17 liegen jeweils bündig an den Anlageflächen 43 an, wobei die Anlageflächen 43 jeweils parallel zu der zugeordneten Einkoppelfläche 21 orientiert sind.

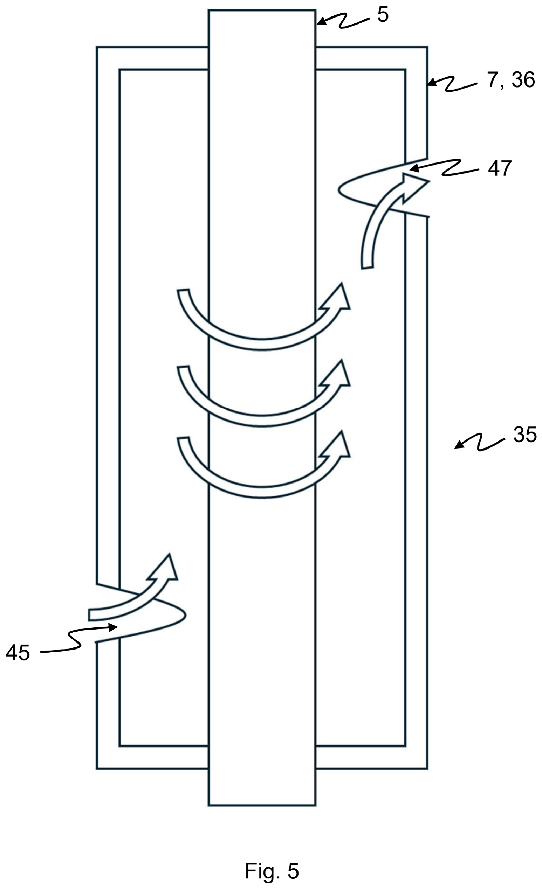

**Fig. 5** zeigt eine zweite Detaildarstellung eines Ausführungsbeispiels einer Pumpvorrichtung 3.

Die Pumpkammer 7 weist hier eine Kammer-Zufuhröffnung 45 und eine Kammer-Abfuhröffnung 47 für das Kühlmedium auf, sodass sie im Betrieb der Pumpvorrichtung 3 von dem Kühlmedium durchströmt ist. Insbesondere wird das Lasermedium 5 auf diese Weise im Betrieb der Pumpvorrichtung 3 von dem Kühlmedium umströmt. Die Pumpkammer 7 kann zusätzlich ein nicht dargestelltes Kammer-Strömungsleitelement aufweisen, das angeordnet und eingerichtet ist, um die Kühlmedienströmung durch die Pumpkammer 7 von der Kammer-Zufuhröffnung 45 zu der Kammer-Abfuhröffnung 47 zu leiten.

Bevorzugt weist das hier nicht dargestellte Lichtleitmedium 11 eine erste Brechzahl auf, die an eine im Betrieb im Inneren der Pumpkammer 7 herrschende, zweite Brechzahl angepasst ist. Dabei kann die erste Brechzahl identisch zu der zweiten Brechzahl sein, oder eine Abweichung zwischen den Brechzahlen beträgt höchstens 0,5, insbesondere höchstens 0,49, insbesondere höchstens 0, 12.

Insbesondere bestimmt das die Pumpkammer 7 durchströmende Kühlmedium die zweite Brechzahl; bevorzugt ist die zweite Brechzahl die Brechzahl des Kühlmediums.

In einer Ausführungsform ist das Kühlmedium Wasser.

## Patentansprüche

1. Pumpvorrichtung (3) zum optischen Pumpen eines Lasermediums (5), mit einer Pumpkammer (7) zur Aufnahme des Lasermediums (5), wobei die Pumpvorrichtung (3) eine Pumplichtführung (9) aufweist, die mindestens eine Lichtleitvorrichtung (11) aufweist, die sich von einer zum Halten einer mindestens eine Laserdiode aufweisenden Pumplichtquelle (13) eingerichteten Pumpquellenhalterung (15) der Pumpvorrichtung (3) bis unmittelbar zu der Pumpkammer (7) erstreckt, wobei die mindestens eine Lichtleitvorrichtung (11) ein als für die Strahlung der Pumplichtquelle (13) transparenter Volumenkörper (17) ausgebildetes Lichtleitmedium (19) aufweist, wobei das Lichtleitmedium (19) im Bereich der Pumpquellenhalterung (15) eine Einkoppelfläche (21) aufweist, die derart ausgebildet ist, dass die Strahlung der Pumplichtquelle (13) in die Lichtleitvorrichtung (11) eingekoppelt werden kann, wenn die Pumplichtquelle (13) an der Pumpquellenhalterung (15) angeordnet ist, und wobei das Lichtleitmedium (19) keilförmig, mit zwei konvergenten Seitenflächen (23), ausgebildet ist, wobei sich die konvergenten Seitenflächen (23) in einer gedachten Ebene, die senkrecht auf einer Längsachse (L) der Pumpkammer (7) steht, einander in Richtung der Pumpkammer (7) annähern, wobei das Lichtleitmedium (19) unmittelbar an die Pumpkammer (7) angrenzt, wobei zwischen der Pumpkammer (7) und dem Lichtleitmedium (19) kein Luftspalt vorhanden ist, und wobei sich das Lichtleitmedium (19) optisch durchgehend zwischen der Pumpquellenhalterung (15) und der Pumpkammer (7) erstreckt.

2. Pumpvorrichtung (3) nach Anspruch 1, wobei die Pumpquellenhalterung (15) und die Einkoppelfläche (21) derart eingerichtet und aufeinander abgestimmt sind, dass ein Laserdiodenarray (29) als Pumplichtquelle (13) an der Pumpquellenhalterung (15) angeordnet und die Strahlung des Laserdiodenarrays (29) in die Einkoppelfläche (21) eingekoppelt werden kann.

3. Pumpvorrichtung (3) nach Anspruch 2, wobei ein Laserdiodenarray (29) an der Pumpquellenhalterung (15) als Pumplichtquelle (13) angeordnet ist, und wobei die Pumpquellenhalterung (15) und das Lichtleitmedium (19) derart eingerichtet und aufeinander abgestimmt sind, dass schnelle Achsen der Laserdioden des Laserdiodenarrays (29) parallel zu der Längsachse (L) der Pumpkammer (7) ausgerichtet ist.

4. Pumpvorrichtung (3) nach Anspruch 3, wobei die Einkoppelfläche (21) mindestens so groß ist wie eine Abstrahlfläche (25) des Laserdiodenarrays (29).

5. Pumpvorrichtung (3) nach einem der vorhergehenden Ansprüche, wobei das keilförmige Lichtleitmedium (19) derart angeordnet und eingerichtet ist, dass sich die konvergenten Seitenflächen (23) entlang langsamer Achsen der Laserdioden des Laserdiodenarrays (29) gegenüberliegen.

6. Pumpvorrichtung (3) nach einem der vorhergehenden Ansprüche, wobei das Lichtleitmedium (19) eine zu einer im Betrieb der Pumpkammer (7) im Inneren der Pumpkammer (7) herrschenden Brechzahl angepasste Brechzahl aufweist.

7. Pumpvorrichtung (3) nach einem der vorhergehenden Ansprüche, wobei ein Konvergenzwinkel, den die konvergenten Seitenflächen (23) des Lichtleitmediums (19) miteinander einschließen, derart auf die Strahlung der Pumplichtquelle (13) abgestimmt ist, dass sich an den Seitenflächen (23) Totalreflexion der Strahlung einstellt, wobei optional Rückreflexion der Strahlung an den Seitenflächen (23) in die Pumplichtquelle (13) vermieden wird.

8. Pumpvorrichtung (3) nach einem der vorhergehenden Ansprüche, wobei die Pumplichtführung (9) eine Mehrzahl von entlang einer Umfangsrichtung der Pumpkammer (7) zueinander versetzt angeordneten Pumpquellenhalterungen (15) aufweist, wobei jeder Pumpquellenhalterung (15) eine Lichtleitvorrichtung (11) zugeordnet ist, wobei optional die Pumpquellenhalterungen (15) derart zueinander versetzt angeordnet sind, dass sich keine zwei Pumplichtquellen (13) diametral gegenüberliegen, und wobei optional die Pumplichtführung (9) eine ungerade Anzahl an - insbesondere genau drei oder genau fünf - Pumpquellenhalterungen (15) aufweist.

9. Pumpvorrichtung (3) nach einem der vorhergehenden Ansprüche, wobei die Pumpkammer (7) mindestens einen der mindestens einen Pumpquellenhalterung (15) diametral gegenüberliegenden reflektierenden Wandungsbereich (31) aufweist.

10. Pumpvorrichtung (3) nach einem der vorhergehenden Ansprüche, wobei das keilförmige Lichtleitmedium (19) zusätzlich zu den zwei konvergenten Seitenflächen (23) zwei weitere, einander gegenüberliegende Grenzflächen (33) aufweist, die zueinander parallel orientiert sind oder sich in Richtung der Pumpkammer (7) öffnen.

11. Pumpvorrichtung (3) zum optischen Pumpen eines Lasermediums (5), insbesondere nach einem der vorhergehenden Ansprüche, wobei die Pumpvorrichtung (3) eine Pumpkammer (7) zur Aufnahme des Lasermediums (5), eine Pumplichtführung (9) zur Führung und Formung von Pumpstrahlung und eine Kühlmedienführung (35) zur Führung eines Kühlmediums aufweist, wobei die Kühlmedienführung (35) eingerichtet ist, um das Kühlmedium an zumindest eine Kühlstelle (36) zu führen, die ausgewählt ist aus der Pumpkammer (7) und mindestens einer Pumpquellenhalterung (15).

12. Pumpvorrichtung (3) nach einem der vorhergehenden Ansprüche, wobei die mindestens eine Pumpquellenhalterung (15) eingerichtet ist, um Wärme von einer an der Pumpquellenhalterung (15) angeordneten Pumplichtquelle (13) abzuführen.

13. Pumpvorrichtung (3) nach einem der vorhergehenden Ansprüche, wobei mindestens zwei Komponenten, ausgewählt aus der Gruppe, bestehend aus der Pumpkammer (7), der Pumpquellenhalterung (15), der Kühlmedienführung (35), der Pumplichtführung (9), der Lichtleitvorrichtung (11), dem transparenten Volumenkörper (17), und einer Kombination der genannten Komponenten, miteinander einstückig, optional materialeinheitlich, ausgebildet sind.

14. Pumpvorrichtung (3) nach einem der vorhergehenden Ansprüche, wobei in der Pumpkammer (7) ein Kühlmedium angeordnet ist, das eine an eine Brechzahl des Lichtleitmediums (19) angepasste Brechzahl aufweist.

15. Laseranordnung (1), mit einem Lasermedium (5) und mindestens einer Pumpvorrichtung (3) nach einem der vorhergehenden Ansprüche.

16. Laseranordnung (1) nach Anspruch 15, wobei als die mindestens eine Pumpvorrichtung (3) eine Mehrzahl an Pumpvorrichtungen (3) entlang einer Längsachse (L) ihrer Pumpkammern (7) nebeneinander angeordnet sind.
